# EUROPÄISCHE PATENTANMELDUNG

(11) **EP 2 854 172 A2**
(43) Veröffentlichungstag der Anmeldung: **01.04.2015**
(21) Anmeldenummer: 14176900.0
(22) Anmeldetag: 14.07.2014
(51) Int. Cl.: H01L 23/373, H01L 23/36, H01L 21/48

(54) **Verfahren zur Herstellung einer Leistungshalbleitereinrichtung mit einer Lotverbindung**

(30) Priorität: 30.09.2013 DE 102013110812
(71) Anmelder: SEMIKRON Elektronik GmbH & Co. KG, 90431 Nürnberg (DE)
(72) Erfinder: Mohl, Norbert, 91189 Regelsbach (DE)

(57) **Zusammenfassung**

Es wird ein Verfahren zur Herstellung einer Leistungshalbleitereinrichtung mit einer Grundplatte und einem stoffschlüssig mittels einer Lotverbindung hiermit verbundenem Substrat mit den folgenden Verfahrensschritten vorgestellt: Bereitstellen der Grundplatte und des Substrats; Anordnen eines weitergebildeten Metallformkörpers auf einer Verbindungsfläche der Grundplatte oder des Substrats, wobei dieser weitergebildete Metallformkörper einen Metallformkörper mit von einer Oberfläche aus eingebrachten Partikeln aufweist, wobei diese Partikel einen minimalen Durchmesser aufweisen, der zwischen 80% und 100% der Dicke der späteren Lotverbindung entspricht; Anordnen der Grundplatte zu dem Substrat, wobei der weitergebildete Metallformkörper zwischen den Verbindungsflächen zu liegen kommt; Temperaturbeaufschlagung mit einer Verbindungstemperatur, die höher liegt als die Schmelztemperatur des Metallformkörpers, wobei der Metallformkörper aufschmilzt, die Partikel in den aufgeschmolzenen Metallformkörper eindringen und eine Lotverbindung entsteht. Weiterhin wird ein Verfahren zu Herstellung des weitergebildeten Metallformkörpers mittels Einpressen der Partikel in den Metallformkörper vorgestellt.

## Beschreibung

Die Erfindung beschreibt ein Verfahren zur Herstellung einer Leistungshalbleitereinrichtung mit einer Lotverbindung zwischen Substrat und Grundplatte, sowie ein Verfahren zur Herstellung eines hierbei Verwendung findenden speziell weitergebildeten Metallformkörpers.

Eine derartige Leistungshalbleitereinrichtung kann beispielhaft ausgebildet sein als ein Leistungshalbleitermodul mit einem Substrat und mit einer metallischen Grundplatte. Derartige Leistungshalbleitermodule sind beispielhaft bekannt aus der DE 10 2005 055 713 A1.

Eine derartige Leistungshalbleitereinrichtung kann allerdings auch als ein Submodul eines leistungselektronischen Systems ausgebildet sein, wie es beispielhaft aus der DE 10 2010 043 446 A1 bekannt ist. In diesem Fall kann die Grundplatte zusätzliche Kühleinrichtungen aufweisen und somit insgesamt als Kühlkörper ausgebildet sein.

Aus dem Stand der Technik, beispielhaft bereits offenbart in der Auslegeschrift DE1 226 715, ist es weiterhin bekannt bei zwei mittels eine Lotschicht verbundenen Verbindungspartner in der Lotschicht Abstandshalteelemente vorzusehen, um eine minimale Dicke der Lotschicht sicher zu stellen.

In Kenntnis der genannten Gegebenheiten liegt der Erfindung die Aufgabe zugrunde, ein besonders einfaches und effektives Verfahren zur Herstellung einer Leistungshalbleitereinrichtung mit einer Lotverbindung definierter, minimaler Dicke zwischen Substrat und Grundplatte, sowie ein Verfahren zur Herstellung eines hierbei Verwendung findenden speziell weitergebildeten Metallformkörpers vorzustellen.

Diese Aufgabe wird erfindungsgemäß gelöst durch ein Verfahren mit den Merkmalen des Anspruchs 1, sowie durch ein Verfahren mit den Merkmalen des Anspruchs 5. Bevorzugte Ausführungsformen sind in den jeweiligen abhängigen Ansprüchen beschrieben.

Das erfindungsgemäße Verfahren zur Herstellung einer Leistungshalbleitereinrichtung mit einer metallischen Grundplatte und einem stoffschlüssig mittels einer Lotverbindung definierter, minimaler Dicke hiermit verbundenem Substrat weist einen zeitlichen Ablauf der folgenden Verfahrensschritte auf:
A. Bereitstellen der Grundplatte und des Substrats, wobei beide jeweils eine Verbindungsfläche aufweisen, die die jeweiligen Kontaktflächen der späteren Lotverbindung zwischen dem Substrat und der Grundplatte ausbilden;
B. Anordnen eines weitergebildeten Metallformkörpers auf der Verbindungsfläche der Grundplatte oder des Substrats, wobei dieser weitergebildete Metallformkörper einen Metallformkörper mit von einer Oberfläche aus eingebrachten Partikeln aufweist, wobei diese Partikel einen minimalen Durchmessers aufweisen, der zwischen 80% und 100% der Dicke der späteren Lotverbindung entspricht; der Metallformkörper kann in bevorzugter Weise als ein Lotplättchen, also als ein flächiger Körper aus einem als Lot dienenden Metall, ausgebildet sein;
C. Anordnen der Grundplatte zu dem Substrat, wobei der weitergebildete Metallformkörper zwischen den Verbindungsflächen zu liegen kommt; hierbei liegt der Metallformkörper auf einer Verbindungsfläche auf, während die andere Verbindungsfläche sich mit zumindest einigen der Partikel in Kontakt befindet.
D. Temperaturbeaufschlagung der Leistungshalbleitereinrichtung mit einer Verbindungstemperatur, die höher, bevorzugt maximal 100°C höher, liegt als die Schmelztemperatur des Metallformkörpers, wobei der Metallformkörper aufschmilzt, die Partikel vollständig in den aufgeschmolzenen Metallformkörper eindringen und aus dem Metallformkörper eine Lotverbindung mit einer Lotschicht definierter, minimaler Dicke entsteht, die an beiden Verbindungsflächen stoffschlüssig anliegt. Vorzugsweise handelt es sich hierbei um dicke Lotschichten im Bereiche zwischen 100µm und 600µm. Grundsätzlich ist das Verfahren aber nicht auf diesen Bereich beschränkt. Es können auch Lotschichten von 20µm bis 100µm oder auch bis zu eine Dicke im Bereich von 2mm mit diesem Verfahren hergestellt werden.

Unter einem minimalen Durchmesser soll hier diejenige Streckenlänge verstanden werden, die den geringsten Wert der Streckenlänge aller Strecken aufweist, die durch den Schwerpunkt des Partikels verlaufen. Analog hierzu ist ein maximaler Durchmesser definiert.

Es ist bevorzugt, wenn das Substrat eine Mehrzahl von Leiterbahnen aufweist und wenn vor dem Verfahrensschritt A) auf den Leiterbahnen des Substrats ein, oder mindestens ein, Leistungshalbleiterbauelement angeordnet wird und intern mittels einer Verbindungseinrichtung schaltungsgerecht verbunden wird. Weiterhin ist es bevorzugt, wenn Anschlusselemente der Leistungshalbleitereinrichtung angeordnet und mit dem Substrat und dem mindestens einen Leistungshalbleiterbauelement schaltungsgerecht verbunden werden.

Es kann vorteilhaft sein, wenn die Verbindungsfläche des Substrats als Teil einer metallischen Schicht dieses Substrats ausgebildet ist.

Das erfindungsgemäße Verfahren zur Herstellung eines o.g. weitergebildeten Metallformkörpers mit von einer Oberfläche aus eingebrachten Partikeln mit einem minimalen Durchmessers weist im zeitlichen Ablauf folgende Verfahrensschritte auf:
a) Bereitstellen des Metallformkörpers;
b) Aufbringen der Partikel auf der Oberfläche;
c) Einpressen der Partikel in die Oberfläche, so dass diese zumindest zu einem Viertel ihres minimalen Durchmessers von der Oberfläche in den Metallformkörper eindringen. Es ist hierbei vorteilhaft, wenn die Partikel zumindest zur Hälfte insbesondere zumindest zu 60% ihres minimalen Durchmessers in den Metallformkörper eindringen.

Es kann weiterhin von Vorteil sein, wenn die Partikel die Form einer Kugel oder einer deformierten Kugel mit einem Verhältnis von minimalem Durchmesser zu maximalen Durchmesser von 2 zu 3, insbesondere von 4 zu 5, vorliegen. Alternativ können die Partikel die Form eines regelmäßigen Polygons oder eines unregelmäßigen Polygons mit einem Verhältnis von minimalem Durchmesser zu maximalen Durchmesser von 2 zu 3, insbesondere von 4 zu 5, aufweisen. Es kann auch vorteilhaft sein, beide Ausgestaltungen der Partikel gemeinsam mit aneinander angepassten Durchmessern zu verwenden.

Es ist besonders bevorzugt, wenn die Partikel aus einem metallischen Werkstoff oder aus einem keramischen Werkstoff oder aus einem metall-keramischen Verbundwerkstoff ausgebildet sind. Selbstverständlich können auch hierbei verschieden Ausgestaltungen gleichzeitig Verwendung finden. Zudem können die Partikel zusätzlich eine Oberflächenbeschichtung mit einem Flussmittel aufweisen, insbesondere um eine Benetzbarkeit ihrer Oberfläche herzustellen.

Bevorzugt und ausreichend ist es meist, wenn die Oberfläche des Metallformkörpers zu mindesten 2%, insbesondere zu mindestens 10% von einzupressenden bzw. eingepressten Partikeln bedeckt ist.

Unter "bedecken" wird hier und im Folgenden die Fläche der senkrechten Projektion der Partikel auf die Oberfläche verstanden.

Vorteilhafterweise werden die Partikel mittels eines Walzverfahrens oder mittels eines Linearpressverfahrens, wobei eine zur Oberfläche orthogonale, also in Richtung des Normalenvektors verlaufende, Druckrichtung bevorzugt ist, von der Oberfläche in den Metallformkörper eingepresst.

Insbesondere bei einem Walzverfahren ist es besonders vorteilhaft, wenn vor dem Verfahrensschritt b) Vertiefungen in die Oberfläche des Metallformkörpers gepresst werden in denen die Partikel vor und während des Einpressens zu liegen kommen. Insbesondere bei einem Linearpressverfahrens ist es besonders vorteilhaft, wenn oberhalb der Oberfläche eine Matrixführung angeordnet ist und die Partikel beim Verfahrensschritt b) in dieser Matrixführung angeordnet sein. Hierbei können die Partikel regelmäßig oder auch unregelmäßig angeordnet werden.

Auch kann es bevorzugt sein, wenn während des Einpressens der Metallformkörper eine Einpresstemperatur T_{E} aufweist, die folgender Bedingung gehorcht: 80°C <T_{E} < (T_{S} - 50°C), wobei T_{S} die Schmelztemperatur des Metallformkörpers ist.

Es versteht sich, dass die verschiedenen Ausgestaltungen der Erfindung einzeln oder in beliebigen Kombinationen realisiert sein können, um Verbesserungen zu erreichen. Insbesondere sind die vorstehend genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterungen der Erfindung, vorteilhafte Einzelheiten und Merkmale, ergeben sich aus der nachfolgenden Beschreibung der in den Figuren 1 bis 9 schematisch dargestellten Ausführungsbeispiele der erfindungsgemäßen Verfahren oder von Teilen hiervon.

Figur 1 zeigt eine mittels des erfindungsgemäßen Verfahrens hergestellte Leistungshalbleitereinrichtung.

Figur 2 bis 4 zeigen verschiedene Ausgestaltungen des Verfahren zur Herstellung eines weitergebildeten Metallformkörpers nach dem Verfahrensschritt b).

Figur 5 zeigt den Beginn des Einpressens, also den Beginn des Verfahrensschritts c).

Die Figuren 6 und 7 zeigen verschiedene Ausgestaltungen des Verfahren zur Herstellung eines weitergebildeten Metallformkörpers nach dem Verfahrensschritt c).

Figur 8 zeigt eine Draufsicht auf einen weitergebildeten Metallformkörper nach Verfahrensschritt c).

Figur 9 zeigt zwei Varianten von deformierten bzw. unregelmäßigen Partikeln.

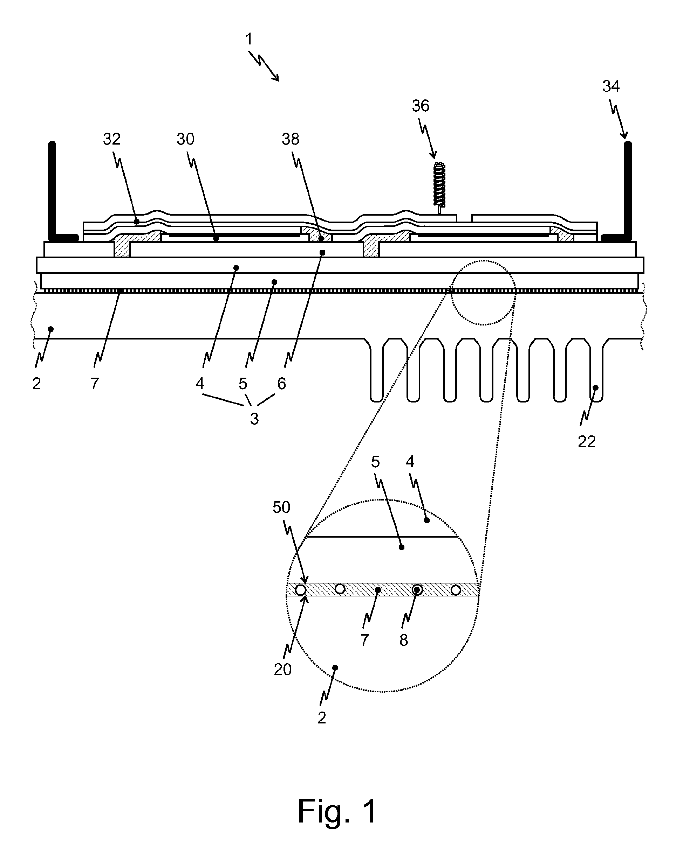

Figur 1 zeigt eine Leistungshalbleitereinrichtung 1 hergestellt mittels des erfindungsgemäßen Verfahrens. Dargestellt ist ein grundsätzlich fachüblich ausgebildetes Substrat 3 mit einem Isolierstoffkörper 4 und hierauf angeordneten jeweils elektrisch voneinander isolierten Leiterbahnen 6, die unterschiedliche Potentiale, insbesondere Lastpotentiale, aber auch Hilfs-, insbesondere Schalt- und Messpotentiale aufweisen. Konkret dargestellt sind hier drei Leiterbahnen 6 mit Lastpotentialen wie sie für eine Halbbrückentopologie typisch sind.

Auf zwei Leiterbahnen 6 ist jeweils ein Leistungsschalter 30 angeordnet, der fachüblich als Einzelschalter, beispielhaft als MOS-FET, oder als IGBT mit antiparallel geschalteter Leistungsdiode ausgebildet sein. Die Leistungsschalter 30 sind fachüblich, bevorzugt mittels einer stoffschlüssigen Verbindung, mit den Leiterbahnen 6 elektrisch leitend verbunden.

Die internen Verbindungen der Leistungshalbleitereinrichtung 1 sind ausgebildet mittels einer Verbindungseinrichtung 32 aus einem Folienverbund, der alternierend elektrisch leitende und elektrisch isolierende Folien aufweist. Alternativ hierzu sind Drahtbondverbindungen häufig genutzter Stand der Technik. Weiterhin ist eine isolierende Masse 38 am Randbereich der Leistungshalbleiterbauelement 30 angeordnet. Diese isolierende Masse 38 kann zusätzlich auch in den Zwischenräumen der Leiterbahnen 6 angeordnet werden.

Zur elektrischen Anbindung weist die Leistungshalbleitereinrichtung 1 Last- 34 und Hilfsanschlusselemente 36 auf. Diese Lastanschlusselemente 34 sind rein beispielhaft als metallischer Formkörper ausgebildet, die mit einem Kontaktfuß mit einer Leiterbahn 6 des Substrats 3 stoffschlüssig verbunden sind. Die Hilfsanschlusselemente 34, wie Gate- oder Sensoranschlüsse, sind fachüblich, hier beispielhaft als Federkontakte, ausgebildet.

Das Substrat 3 weist auf seiner den Leiterbahnen 6 gegenüberliegenden Seite eine metallische Schicht 5 auf. Fachüblich, allerdings nicht einschränkend, ist ein derartiges Substrat 3 bespielhaft als DCB (direct copper bonding) Substrat ausgebildet. Diese metallische Schicht 5 weist eine Oberfläche auf, die zumindest abschnittweise die Verbindungsfläche 50 des Substrats 3 ausbildet, die der stoffschlüssigen Verbindung, hier der Lotverbindung 7, mit einer Grundplatte 2 dient.

Die Grundplatte 2 selbst ist hier fachüblich als eine Kupferplatte ausgebildet, kann allerdings zusätzliche Kühlelemente 22, wie im rechten Teil der Figur 1 dargestellt aufweisen und dient somit auch explizit als Kühlkörper. Die Grundplatte 2 weist dem Substrat 3 zugewandt eine Oberfläche auf, die zumindest abschnittweise die Verbindungsfläche 20 der Grundplatte 2 ausbildet, die der stoffschlüssigen Verbindung, hier der Lotverbindung 7, mit dem Substrat 3 dient.

Die Lotverbindung 7 zwischen dem Substrat 3 und der Grundplatte 2 wird mittels einer Lotschicht definierter, minimaler Dicke, hier ca. 300µm, ausgebildet. In dieser Lotschicht 7 sind in fachüblicher Weise Partikel 8 mit einem minimalen Durchmesser von ca. 280µm angeordnet. Mittels dieser Partikel 8 wird sichergestellt, dass die Lotschicht 7 mindestens diese Dicke aufweist. Bei praktischer Ausführung wird die Lotschicht 7 immer ein wenig dicker ausgebildet sein als der minimale Durchmesser der Partikel 8, auch falls die Partikel 8 im Rahmen der technischen Ausführbarkeit kugelförmig sind.

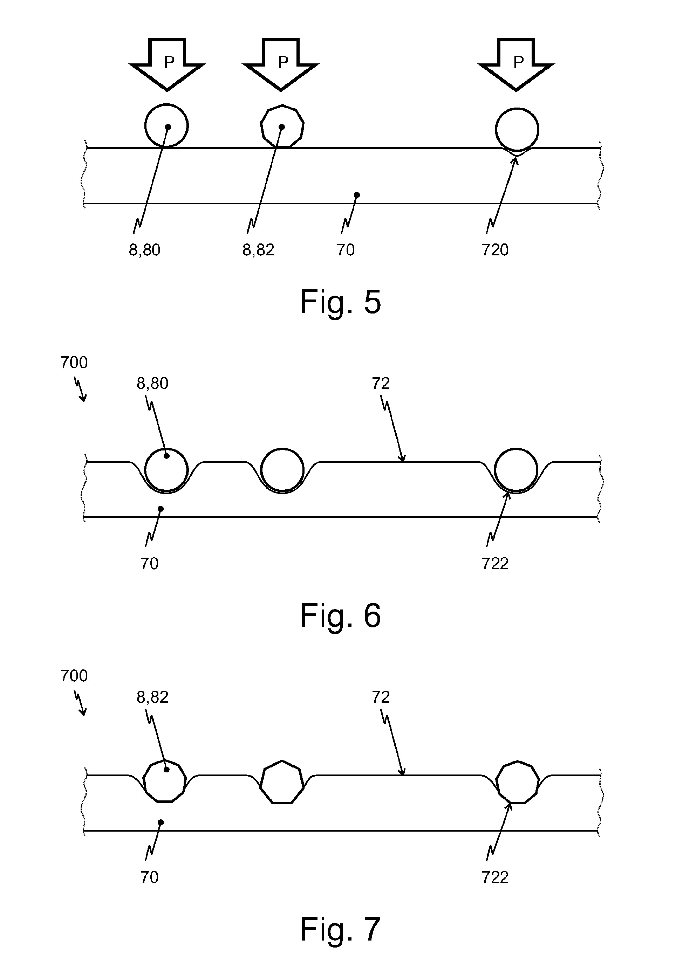

Im Rahmen der Herstellung dieser Leistungshalbleitereinrichtung 1 wird ein weitergebildeter Metallformkörper 700 (vgl. Fig. 6 bis 8) aus fachüblichem Lotmaterial auf der Verbindungsfläche 20 der Grundplatte 2 angeordnet. In diesem weitergebildeten Metallkörper 700 sind zu diesem Zeitpunkt Partikel 8 angeordnet, die von seiner der Verbindungsfläche 20 der Grundplatte 2 abgewandten Oberfläche 72 aus in den Metallformkörper 70 eingepresst sind. Die hier kugelförmigen Partikel 8, 80 sind hierbei zu ca. der Hälfte ihres Durchmessers in den Metallformkörper 70 eingepresst, ragen also zur anderen Hälfte ihres Durchmessers noch aus der Oberfläche 72 des Metallformkörpers 70 heraus.

Auf diesen aus der Oberfläche 72 herausragenden Partikeln 8 wird anschließend das Substrat 3 angeordnet. In einem weiteren Verfahrensschritt werden die Komponenten der Leistungshalbleitereinrichtung 1 mit einer Verbindungstemperatur beaufschlagt, wodurch der Metallformkörper 70 aufschmilzt. Hierbei sinken die Partikel 8 in den aufgeschmolzenen Metallformkörper 70 ein. Es kann hierbei sinnvoll sein das Substrat 3 mit einem moderaten Druck auf die Grundplatte 2 zu drücken. Der aufgeschmolzene Metallformkörper 70 bildet nach seiner Abkühlung die Lotschicht 7 zwischen dem Substrat 3 und der Grundplatte 2 aus, wobei die Partikel 8 als Abstandshalter für eine definierte, minimale Dicke der Lotschicht 7 dienen.

Selbstverständlich kann sich an das genannte Verfahren noch mindestens ein weiterer Schritt, nämlich die Anordnung eines nicht dargestellten Gehäuses anschließen. Auf diese Weise kann ein Leistungshalbleitermodul bekannter Bauart hergestellt werden. Ebenso kann die Leistungshalbleitereinrichtung beispielhaft mit weiteren identischen Leistungshalbleitereinrichtungen zu einem komplexeren leistungselektronischen System kombiniert werden.

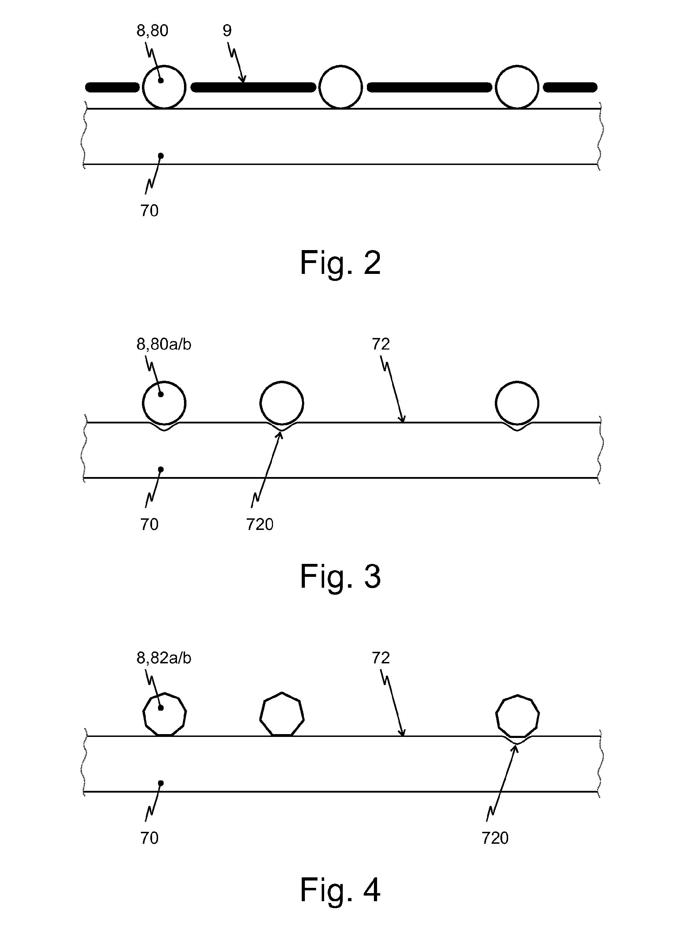

Die Figuren 2 bis 9 zeigen verschiedene Verfahrensschritte zur Herstellung eines weitergebildeten Metallformkörpers 700 mit von einer Oberfläche 72 aus eingebrachten Partikeln 8, in verschiedenen Ausgestaltungen. Die Partikel 8 können hierbei aus einem metallischen Werkstoff oder aus einem keramischen Werkstoff oder aus einem metall-keramischen Verbundwerkstoff ausgebildet sind. Es können auch verschieden ausgebildete Partikel 8 gemeinsam verwendet werden. Zudem können einige oder alle Partikel 8 eine Oberflächenbeschichtung mit einem fachüblichen, bei Normalbedingungen festen oder pastösen, Flussmittel aufweisen.

Figur 2 bis 4 zeigen verschiedene Ausgestaltungen des Verfahren zur Herstellung eines weitergebildeten Metallformkörpers 700 nach dem Verfahrensschritt b). Dargestellt ist jeweils ein Ausschnitt des Metallformkörpers 70 mit einer Oberfläche 72 von der aus die Partikel 8 in diesen eingepresst werden. Meist ist es ausreichend, wenn gemittelt über die Oberfläche 72 des Metallformkörpers 70 diese Oberfläche 72 zu 2% bis 5% von einzupressenden Partikeln 8 bedeckt ist. Falls die Partikel 8 insbesondere auch der Wärmeleitung dienen sollen, kann es vorteilhaft sein die Oberfläche 72 zu mindestens 10% mit Partikeln 8 zu bedecken.

Figur 2 zeigt kugelförmige Partikel 80, die in einer Matrixführung 9 angeordnet sind. Dieser Matrixführung 9 ist ausgebildet als ein siebartiger Körper, wobei in den Öffnungen des Siebes die Partikel 8 zu liegen kommen. Somit kann bevorzugt eine regelmäßige Verteilung der Partikel 8 über der Oberfläche 72 des Metallformkörpers 70 erfolgen.

Figur 3 zeigt wiederum kugelförmige Partikel 80a/b, die in Vertiefungen 720 der Oberfläche 72 des Metallformkörpers 70 angeordnet sind. Diese hier unregelmäßig verteilten Vertiefungen 720 können durch einen geeigneten Druckstempel gleichzeitig erzeugt werden.

Figur 4 zeigt verschiedene polygonförmige Partikel 82a/b auf der Oberfläche 72 des Metallformkörpers 70. Auch bei Verwendung von polygonförmigen Partikeln 80a/b ist es bevorzugt die Oberfläche 72 mit Vertiefungen 720 zu versehen, da hierdurch offensichtlich die gewünschte Positionierung der Partikel 8 leichter erreicht werden kann.

Figur 5 zeigt den Beginn des Einpressens von Partikeln 8 in den Metallformkörper 70 von seiner Oberfläche 72 aus, also den Beginn des Verfahrensschritts c). Die dargestellten Partikel 8 sollen hierbei die Allgemeinheit nicht beschränken. In dieser Ausgestaltung des Einpressens wird ein Linearpressverfahren eingesetzt. Hierbei wirkt ein Druckstempel in Richtung des Normalenvektors der Oberfläche 72 des Metallformkörpers 70, angedeutet durch die Pfeile P, auf die Partikel 8 ein und drückt diese von der Oberfläche 72 aus in den Metallformkörper 70.

Es hat sich als vorteilhaft erwiesen während des Einpressens den Metallformkörper 70 auf eine Einpresstemperatur T_{E} zu erwärmen, da hierdurch der aufzuwendende Druck geringer sein kann. Die bevorzugte Einpresstemperatur T_{E} liegt für fachübliche Metallformkörper 70, also Lote, im Bereich von 150°C bis 200°C. Allgemein sollte die Einpresstemperatur T_{E} folgender Bedingung gehorchen: 80°C < T_{E} < (T_{S} - 50°C), wobei T_{S} die Schmelztemperatur des Metallformkörpers 70 ist.

Die Figuren 6 und 7 zeigen verschiedene Ausgestaltungen des Verfahren zur Herstellung eines weitergebildeten Metallformkörpers 700 nach dem Verfahrensschritt c). Hierbei sind die Partikel 8, in Figur 6 kugelförmig und in Figur 7 polygonförmig, jeweils zu 50% bis 60% ihres minimalen Durchmessers in den Metallformkörper 70 eingepresst. Eine höhere Genauigkeit der Einpresstiefe ist nicht notwendig. Eine Einpresstiefe von 60% bis 75% kann allerdings die Handlingeigenschaften des weitergebildeten Metallformkörpers 700 insbesondere bei der Herstellung einer Leistungshalbleitereinrichtung verbessern.

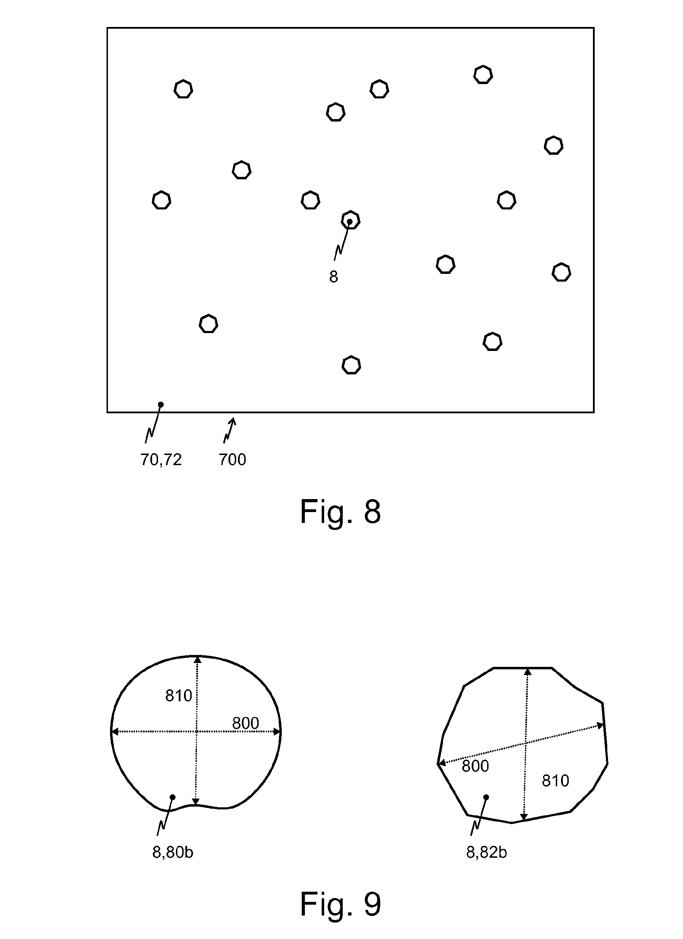

Figur 8 zeigt eine Draufsicht auf eine Oberfläche 72 eines weitergebildeten Metallformkörpers 700 nach Verfahrensschritt c). Die Partikel 8, 82 sind hierbei nicht regelmäßig verteilt. Allerdings sollte die Anzahl der Partikel 8 auf geeignet gewählten Teilflächen der Oberfläche 72 nicht zu stark schwankten. Eine konkrete Teilchendichte pro Teilfläche muss allerdings anwendungsspezifisch, bevorzugt empirisch, ermittelt werden.

Figur 9 zeigt zwei Varianten von deformierten bzw. unregelmäßigen Partikeln. Links dargestellt ist ein Partikel 80b in Form einer deformierten Kugel, während rechts ein Partikel 82b in Form eines unregelmäßigen Polygons dargestellt ist. Hierbei ist es jeweils bevorzugt, wenn das Verhältnis vonminimalem Durchmesser 810 zu maximalen Durchmesser 800 2 zu 3, bevorzugt sogar nur 4 zu 5, beträgt.

## Patentansprüche

1. Verfahren zur Herstellung einer Leistungshalbleitereinrichtung (1) mit einer metallischen Grundplatte (2) und einem stoffschlüssig mittels einer Lotverbindung (7) hiermit verbundenem Substrat (3) mit den folgenden Verfahrensschritten im zeitlichen Ablauf
A. Bereitstellen der Grundplatte (2) und des Substrats (3), wobei beide jeweils eine Verbindungsfläche (20, 40) aufweisen, die die jeweiligen Kontaktflächen der späteren Lotverbindung (7) zwischen dem Substrat (3) und der Grundplatte (2) ausbilden;
B. Anordnen eines weitergebildeten Metallformkörpers (700) auf der Verbindungsfläche (20, 40) der Grundplatte (2) oder des Substrats (3), wobei dieser weitergebildete Metallformkörper (700) einen Metallformkörper (70) mit von einer Oberfläche (72) aus eingebrachten Partikeln (8) aufweist, wobei diese Partikel (8) einen minimalen Durchmesser aufweisen, der zwischen 80% und 100% der Dicke der späteren Lotverbindung entspricht;
C. Anordnen der Grundplatte (2) zu dem Substrat (3), wobei der weitergebildete Metallformkörper (700) zwischen den Verbindungsflächen (20, 40) zu liegen kommt;
D. Temperaturbeaufschlagung der Leistungshalbleitereinrichtung (1) mit einer Verbindungstemperatur, die höher liegt als die Schmelztemperatur des Metallformkörpers (70), wobei der Metallformkörper (70) aufschmilzt, die Partikel (8) vollständig in den aufgeschmolzenen Metallformkörper (70) eindringen und aus dem weitergebildeten Metallformkörper (700) eine Lotverbindung (7) mit einer Lotschicht definierter, minimaler Dicke entsteht.

2. Verfahren nach Anspruch 1, wobei
das Substrat (3) eine Mehrzahl von Leiterbahnen (6) aufweist und wobei vor dem Verfahrensschritt A) auf den Leiterbahnen (6) des Substrats (3) ein Leistungshalbleiterbauelement (30) angeordnet wird und intern mittels einer Verbindungseinrichtung (32) schaltungsgerecht verbunden wird und wobei weiterhin Anschlusselementen (34, 36) der Leistungshalbleitereinrichtung (1) angeordnet werden.

3. Verfahren nach Anspruch 1 oder 2, wobei
die Verbindungsfläche (40) des Substrats (3) als Teil einer metallischen Schicht (4) dieses Substrats (3) ausgebildet ist.

4. Verfahren nach einem der Ansprüche 1 bis 3, wobei
die Verbindungstemperatur maximal 100°C über der Schmelztemperatur des Metallformkörpers (70) liegt.

5. Verfahren zur Herstellung eines weitergebildeten Metallformkörpers (700) mit von einer Oberfläche (72) aus eingebrachten Partikeln (8) mit einer minimalen Durchmessers mit den folgenden Verfahrensschritten im zeitlichen Ablauf
a) Bereitstellen des Metallformkörpers (70);
b) Aufbringen der Partikel (8) auf der Oberfläche (72);
c) Einpressen der Partikel (8) in die Oberfläche (72), so dass diese zumindest zu einem Viertel ihres minimalen Durchmessers von der Oberfläche (72) in den Metallformkörper (70) eindringen.

6. Verfahren nach Anspruch 5, wobei
die Partikel (8) zumindest zur Hälfte insbesondere zumindest zu 60% ihres minimalen Durchmessers in den Metallformkörper (70) eindringen

7. Verfahren nach einem der Ansprüche 5 oder 6, wobei die Partikel (8) die Form einer Kugel (80a) oder einer deformierten Kugel (80b) mit einem Verhältnis von minimalem Durchmesser (810) zu maximalen Durchmesser (800) von 2 zu 3, insbesondere von 4 zu 5, aufweist.

8. Verfahren nach einem der Ansprüche 5 oder 6, wobei die Partikel (8) die Form regelmäßigen Polygons (82) oder eines unregelmäßigen Polygons (82b) mit einem Verhältnis von minimalem Durchmesser (810) zu maximalen Durchmesser (800) von 2 zu 3, insbesondere von 4 zu 5, aufweist.

9. Verfahren nach einem der Ansprüche 5 bis 8, wobei die Partikel (8) aus einem metallischen Werkstoff oder aus einem keramischen Werkstoff oder aus einem metall-keramischen Verbundwerkstoff ausgebildet sind.

10. Verfahren nach einem der Ansprüche 5 bis 9, wobei die Partikel (8) eine Oberflächenbeschichtung mit einem Flussmittel aufweisen.

11. Verfahren nach einem der Ansprüche 5 bis 10, wobei die Oberfläche (72) des weitergebildeten Metallformkörpers (700) zu mindestens 2%, insbesondere zu mindestens 10% von eingepressten Partikeln (8) bedeckt ist.

12. Verfahren nach einem der Ansprüche 5 bis 11, wobei die Partikel (8) mittels eines Walzverfahrens oder mittels eines Linearpressverfahrens von der Oberfläche (72) in den Metallformkörper (70) eingepresst werden.

13. Verfahren nach Anspruch 12, wobei
vor dem Verfahrensschritt b) Vertiefungen (720) in die Oberfläche (72) des Metallformkörpers (70) gepresst werden in denen die Partikel (8) vor und während des Einpressens zu liegen kommen.

14. Verfahren nach Anspruch 12, wobei
oberhalb der Oberfläche (72) eine Matrixführung (9) angeordnet ist und die Partikel (8) beim Verfahrensschritt b) in dieser Matrixführung (9) angeordnet werden.

15. Verfahren nach einem der Ansprüche 5 bis 14, wobei während des Einpressens der Metallformkörper (70) eine Einpresstemperatur T_{E} aufweist, die folgender Bedingung gehorcht: 80°C <T_{E} < (T_{S} - 50°C), wobei T_{S} die Schmelztemperatur des Metallformkörpers (70) ist.
